Europäisches Patentamt

(19) European Patent Office

Office européen des brevets

(11) Publication number : **0 247 927 B1**

# (12) EUROPEAN PATENT SPECIFICATION

(45) Date of publication of patent specification :
**29.01.92 Bulletin 92/05**

(51) Int. Cl.⁵ : **G01R 31/28, G01R 31/26**

(21) Application number : **87401112.5**

(22) Date of filing : **15.05.87**

(54) Apparatus and method for high temperature environmental testing of a semiconductor device.

(30) Priority : **16.05.86 JP 110833/86**

(43) Date of publication of application :
**02.12.87 Bulletin 87/49**

(45) Publication of the grant of the patent :
**29.01.92 Bulletin 92/05**

(84) Designated Contracting States :
**DE FR GB**

(56) References cited :
**EP-A- 0 106 196**
**US-A- 4 574 235**

(56) References cited :
**MICROWAVE JOURNAL, vol. 27, no. 5, May 1984, pages 227-242, Dedham, Massachusetts, US; F. WILHEMSEN et al.: "Temperature vs. reliability in power GaAs FETs and MIC GaAs FET power amplifiers" PATENT ABSTRACTS OF JAPAN, vol. 6, no. 116 (P-125)[994], 29th June 1982; & JP-A-57 44 866**

(73) Proprietor : **FUJITSU LIMITED**
**1015, Kamikodanaka Nakahara-ku**
**Kawasaki-shi Kanagawa 211 (JP)**

(72) Inventor : **Usui, Toshio**
**1-4-504, Isogo 5-chome Isogo-ku**
**Yokohama-shi Kanagawa 235 (JP)**

(74) Representative : **Joly, Jean-Jacques et al**
**CABINET BEAU DE LOMENIE 55, rue d'Amsterdam**
**F-75008 Paris (FR)**

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to the high temperature environmental testing of a semiconductor device. Particularly, it relates to an improvement of means for setting the microwave semiconductor device to be tested into the testing apparatus.

Semiconductor devices, particularly the ones employed in critical systems, such as space communication systems, are required to perform a reliable operation under severe environmental conditions for a long period, for example, more than ten years. To evaluate the quality of the semiconductor devices under such conditions, various environmental tests are performed.

For example, a high temperature environmental test of a microwave semiconductor device, is performed at a temperature ranging from 200°C to 250°C for a predetermined period. The test is also indispensable for developing a new semiconductor device for highly reliable use to estimate the life of the new semiconductor device under critical conditions.

A particular problem occurs with the high temperature environmental test of a microwave semiconductor device, such as a gallium arsenide field effect transistor (GaAs-FET) being operable at a frequency up to 18 GHz. Generally, a setting device is used for setting the microwave semiconductor device into the testing apparatus. The setting device includes plates having microstrip matching circuits and relevant connectors for connecting to outer circuits, which are arranged in the extreme proximity of the semiconductor device to be tested, in order to reduce the microwave power reflection due to the sharp transition of the transmitting impedance of the relevant transmission lines.

With such a configuration, in a prior art high temperature environmental testing apparatus, the microstrip circuit plates and the relevant connectors are exposed to a high temperature environment together wit the semiconductor device under test. Thus, during the testing period, the microstrip matching circuits and the relevant connectors are subject to damage to some degree : oxidation of the contacts of the connectors, and chemical and mechanical damage of the microstrip matching circuit plates including microstrip patterns formed on substrates, due to cyclical thermal stresses which are caused by intermittent breaks during the test period for measuring the change of the electric characteristics of the semiconductor device. Damaging of the matching circuits and relevant connectors will affect the reliability of the test results.

A device, having the features defined in the preamble of claim 1, is disclosed in Microwave Journal, vol. 27, n° 5, May 1984, pages 227-242; by F. Wilhelmsen et al., entitled "Temperature vs. reliability in power GaAs FETs and MIC GaAs FET power amplifiers".

Therefore, an object of the present invention is to provide a high temperature environmental testing apparatus having an improved setting device for setting a semiconductor device to be tested.

More particularly, an object of the present invention is to provide a testing apparatus with a setting device having a structure which allows the heat generated by a heating source to flow mainly to the semiconductor device under test, and which limits the heat flow to the relevant matching circuit plates located in the vicinity of the semiconductor device, to avoid damage to the circuits and to obtain a more reliable high temperature environmental testing result.

According to the present invention, the testing apparatus has a setting device, for setting a semiconductor device to be tested, which includes a thermally and electrically conductive base member, said setting device comprising : a microstrip matching circuit having a plurality of microstrip matching circuit plates each plate including an electrically insulative substrate, said microstrip matching circuit being operatively connectable to said semiconductor device; an output terminal means connected to said microstrip matching circuit, for providing said microstrip circuit plates with signals; a grounding means for electrically grounding said semiconductor device; and a heat block for heating said semiconductor device; characterized in that said setting device further comprises : a microstrip matching pattern formed on the top surface of each substrate; a grounding pattern formed on the back side of each substrate, and connected to said output terminal means; a cooling block for cooling said microstrip matching circuit mounted on said cooling block; and supporting means for supporting said heat block, said heat block being attachable to said base member of said semiconductor device in surface-to-surface contact, being heated by a heating source, and being supported by said supporting means such that said heat block is positioned spatially isolated from said cooling block by an air space except for the portion where said supporting means contacts thereto.

The semiconductor device is directly attached to the heat block such that the heat generated in the heat block can be transferred directly to the semiconductor device with negligibly small heat transfer resistance therebetween. On the other hand, microstrip matching circuit plates and the relevant connectors are attached to the cooling block for preventing the temperature rise thereof. Since the major part of the cooling block is spatially isolated from the heat block by an air space existing therebetween, the heat flow from the heat block is almost stopped. As a result, the microstrip matching circuits and the connectors disposed in the setting device, are favorably protected from the temperature rise.

The grounding means for grounding the semiconductor device and the relevant matching circuits may consist in a thin metallic foil which is disposed between the heat block and the semiconductor device, and is connected to the cooling block. In another embodiment, the grounding means is in the form of a small metallic projection, projecting from the cooling block, which can be arranged to contact with the metallic base of the semiconductor device. The ground potential is then applied to the semiconductor device through the cooling block.

Other features and advantages of the present invention will be apparent from the reading of the following description made with respect to the enclosed drawings in which :

Fig. 1 is a perpective view of a setting device in a internal prior art high temperature environmental testing apparatus for testing microwave semiconductor devices ;

Fig. 2 is perspective view of a setting device in a first embodiment of a testing apparatus according to the present invention ;

Fig. 3 is a plan view of the setting device of Fig. 2 ;

Fig. 4 and Fig. 5 are cross-sectional views of the setting device of Fig. 3, taken along line A-A and line B-B,respectively ;

Fig. 6 is a perspective view of a setting device in a high temperature environmental testing apparatus for testing microwave semiconductor devices, according to a second embodiment of the present invention ;

Fig. 7 is a plan view of the setting device of Fig. 6 ;

Fig. 8 and Fig. 9 are cross-sectional views of the setting device of Fig. 7 taken along line C-C and line D-D, respectively ; and

Fig. 10 is a perspective view of an L type seat block illustrated in Fig. 6.

In the drawings, same reference numerals designate same or similar parts.

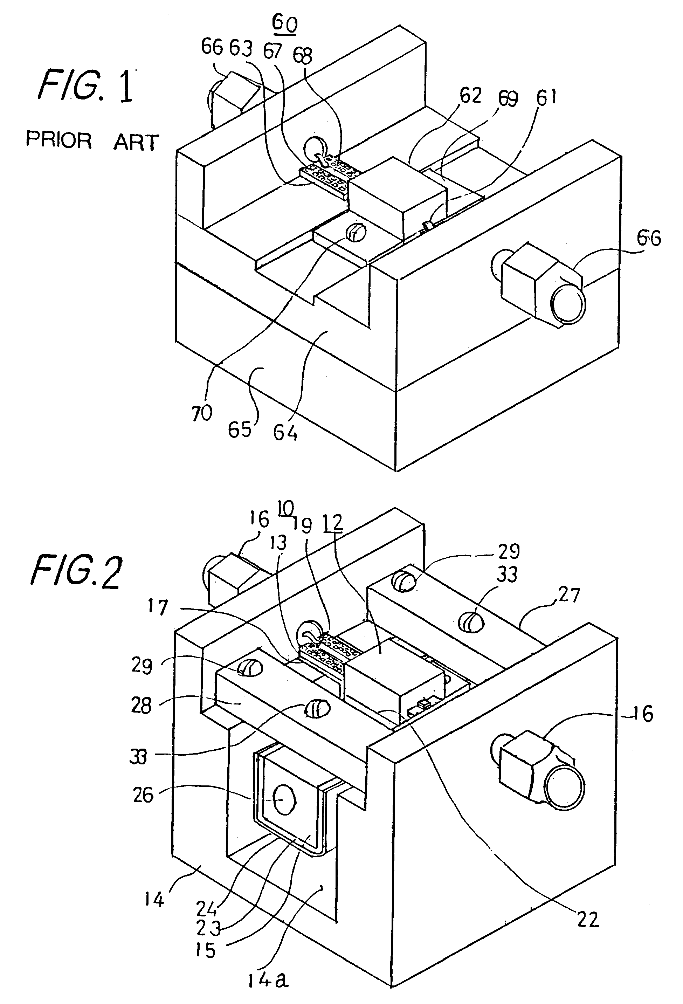

Before describing embodiments of the invention, a setting device for a prior art testing apparatus will be described with reference to Fig. 1.

The setting device shown on Fig. 1 is designed for the high temperature environmental test of a semiconductor device, a GaAs-FET 62, for example. On a base block 64 made of copper or aluminum, microstrip matching circuit plates 60 are provided which are arranged to be connectable to the semiconductor device to be tested. Each circuit plate 60 comprises a substrate 63 made of alumina, polytetrafluoroethylene, etc. , a microstrip pattern 67 including a transmission line 68, formed on the top surface of the substrate 63, and a co-axial connector 66 connected to the transmission line 68. The setting device further includes a heat block 65 made of copper or aluminum, having heating source therein.

The semiconductor device, the GaAs-FET 62, usually has a metallic base 69 and leads 61 for input and output transmission power, and is electrically grounded through the metallic base 69. The FET 62 is set into the high temperature testing apparatus,by using the setting device : the metallic base 69 is tightly attached to the base block 64 using screws 70, the leads 61 are soldered or pressed to the transmission lines 68, and then, the base block 64 is set on the heat block 65 in a face-to-face contact relationship. With such a configuration, the heat generated in the heat block 65 is transferred to the base block 64, and then to the FET 62 through the metallic base 69 to raise the temperature of the FET 62 up to a predetermined testing value, such as 250°C. However, at the same time, the heat is easily transferred to the microstrip matching circuit plates 60 and co-axial connectors 66, raising the temperatures of these elements to a high level close to the testing temperature, resulting in the already mentioned damages.

While, the ground potential is applied to the semiconductor device 62 and to the microstrip matching circuit plates 68 without any problem, because the ground potential is applied to the base block 64.

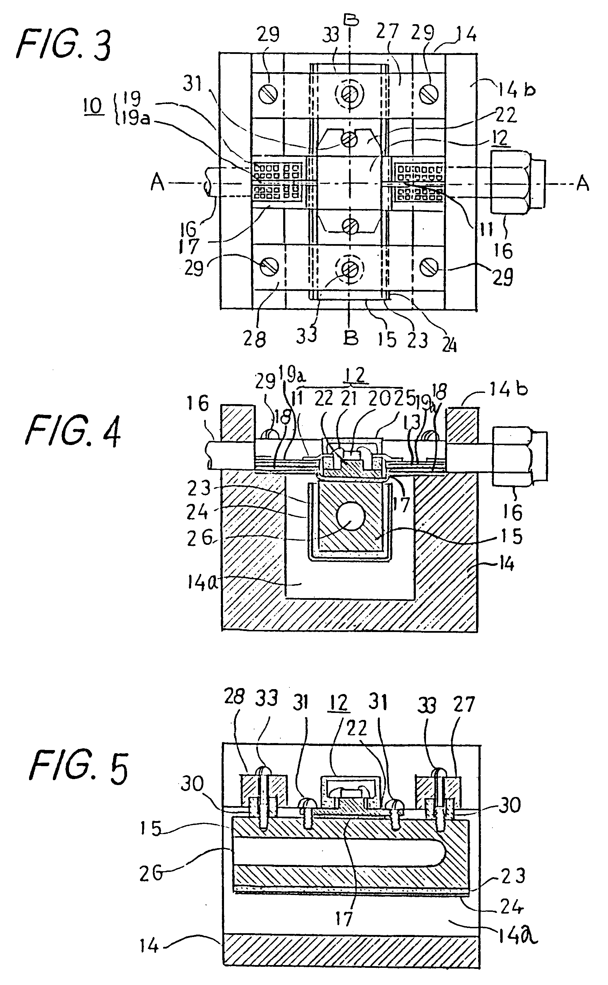

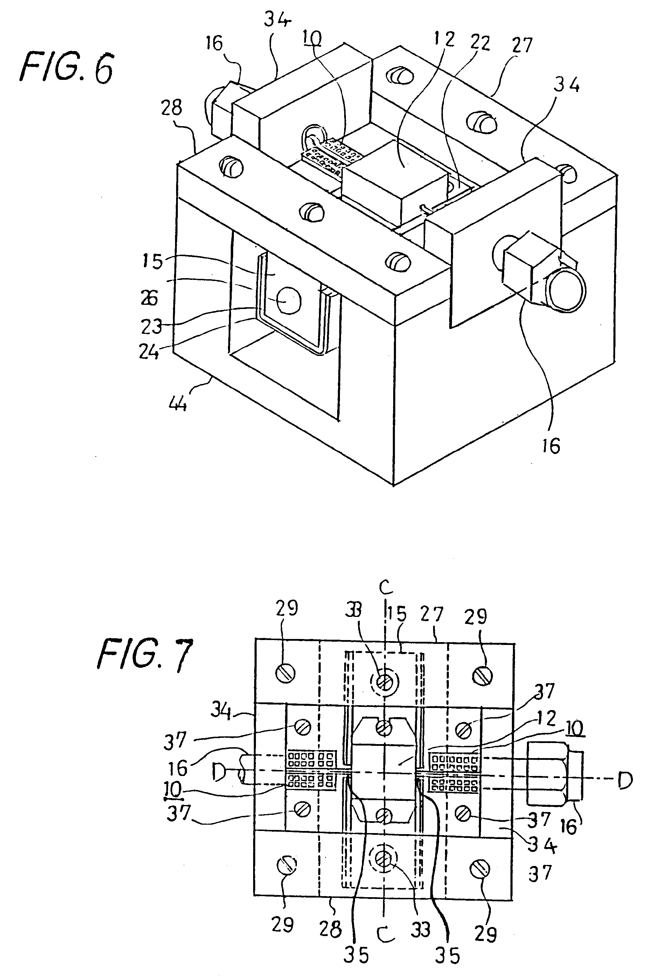

Fig. 2 and Fig. 3 are respectively a perspective view and a plan view of an apparatus according to a first embodiment of the present invention, with a semiconductor device 12 set in the setting device. Fig. 4 and Fig. 5 are respectively cross-sectional views taken along lines A-A and B-B of Fig. 2.

A heat block 15 made of copper, aluminum or brass, has its outer surface, except the top surface, covered by a layer of asbestos 23 and by a stainless steel plate 24 disposed over the asbestos 23, for heat insulation. The heat block 15 is heated by a cartridge type heater 26 (schematically shown) installed therein-side. The heating power of the heater 26 is controlled by an external temperature controller (not shown). A cooling block 14, made of aluminum, has a large moat 14a which runs in the direction B-B. The heat block 15 is sustained in the moat 14a by means of bridge plates 27 and 28, being spatially separated from the cooling block 14 by an air space. The heat block 14 is tightly fixed to the bridge plates 27 and 28 by screws 33, maintaining small gaps therebetween by the aid of ceramic spacers 30, so as to reduce the heat conduction from the heat block 14 to the cooling block 15. While, the bridge plates 27 and 28 are attached to the cooling block 14 by screws 29.

A pair of microstrip matching circuit plates 10 are disposed on the top surface of the cooling block 14 such that the semiconductor device 12 to be tested is operatively connected to the external testing circuits (not shown) therethrough. The matching circuit plate 10 has a conventional structure, comprising a ceramic substrate 13, and a microstrip pattern 19 including a transmission line 19a formed on the top surface of the substrate 13. At the back side of the substrate 13, a ground pattern 18 is formed which contacts the surface of the cooling block 14. A co-axial connector 16 is fixed through a standing wall 14b of the cooling block 14, and electrically connected to the transmission line 19a.

As a means for providing ground potential to the semiconductor device 12, a grounding foil 17, made of a metallic foil, such as a copper foil plated with a gold plating layer 50 µm thick, is stretched across the moat 14a at the center portion of the cooling block 14. The grounding foil 17 is soldered and connected to the grounding pattern 18 of the microstrip matching circuit using gold-silicon alloy solder containing 18% by weight of silicon, (AuSil8). Instead being soldered to the grounding line 18, the grounding foil 17 may be directly soldered to a side wall of the moat 14a formed in the cooling block 14 using a solder material such as gold tin alloy solder containing 25% by weight of tin, AuSn25, or the gold silicon alloy AuSil8.

The semiconductor device to be tested, GaAs-FET 12, has a gallium arsenide chip 20 which is mounted on a metallic base 22, and bonded to leads 11 by bonding wires 21. The chip 20 and bonding wires 21 are protected with a plastic coverage 25. The FET 12 is placed on the ground foil 17, and tightly attached to the heat block 15 by screwing the flange of the metallic base 22 with screws 31. Thus, the grounding foil 17 is also pressed by the metallic base 22 and tightly connected to the heat block 15 without heat transfer resistance. Then, the leads 11 are tightly pressed and deformed to the relevant transmission lines 19a, or are soldered thereto. Thus, the setting of the FET 12 into the setting device is completed. The FET 12 is set in the center of the heat block 15 while the supporting plates 27, 28 are attached to the heat block 15 in the vicinity of the ends thereof.

With above configuration, the heat generated in the heat block 15 is transferred effectively and directly to the FET 12. While, the heat is not allowed to be transferred to the cooling block 14, because the major portion of the heat block 15 is spatially and thermally isolated from the cooling block 14 by an air space, except for the heat path through the supporting means, namely, bridge plates 27 and 28. The ceramic spacers 30 interposed between bridge plates 27 and 28 and the heat block 15 form a heat flow limiting configuration. As a result, according to an experimental measurement, when, for example, the temperature of the FET 12 is maintained at 250°C, the temperature of the matching circuit 10 is kept below 65°C.

While, connection to ground potential, particularly for high frequency power supply, is secured by the ground foil 17, because the cooling block 14 is usually electrically grounded, and the path between the transmission line 19a and the metallic base 22 is sufficiently short to eliminate any harmful microwave impedance therebetween.

A high temperature environmental test can then be performed by inputting a driving signal and outputting a load power to and from the FET 12 through the leads 11, transmission lines 19a and co-axial connectors 16, and by raising the temperature of FET 12 by heating the heat block 15, for a predetermined period, without damaging the microstrip matching circuit plates 10 and the relevant connector 16.

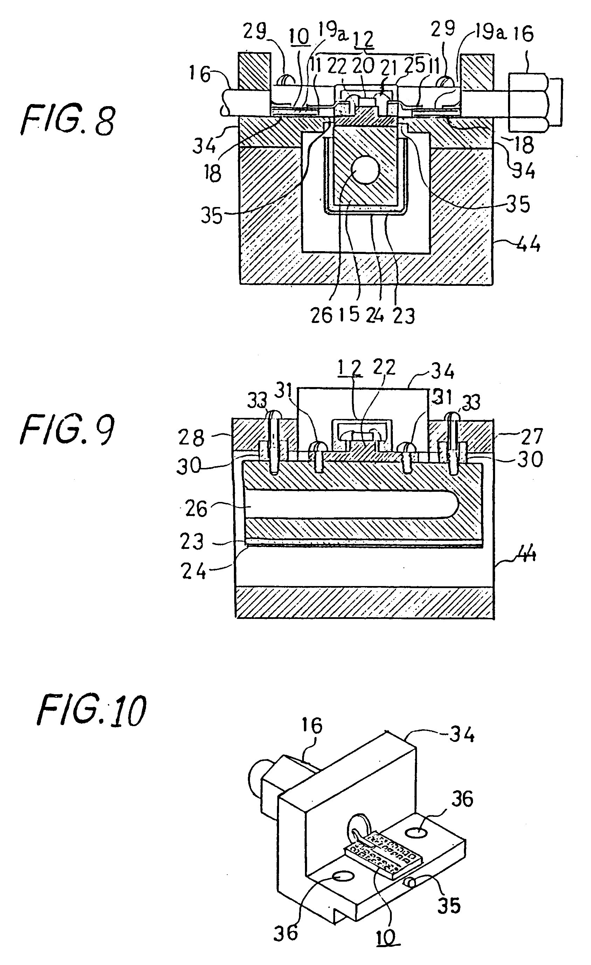

Fig. 6 is a perspective view illustrating a second embodiment of an apparatus according to the invention having a setting device provided with another type of grounding means. Fig. 7 is a plan view of the same, and Fig. 8 and Fig. 9 are cross-sectional views taken along lines C-C and D-D shown in Fig. 7.

In the apparatus of Figs. 6-9, the elements which are identical to corresponding ones of the apparatus of Figs. 2-5 bear the same references and will not be described again.

As is apparent from Figs. 6-9, the grounding means of the setting device is more particularly designed to allow a convenient setting. A cooling block 44, made of aluminum, has a form different from that of the cooling block 14 in the above described first embodiment. Instead of the grounding foil 17 of the preceding embodiment, an L type seat block 34 made of brass, is provided, which is illustrated in perspective view in Fig. 10. On the L type seat block 34, the microstrip matching circuit plates 10 and the co-axial connectors 16 are mounted in the same manner as in the first embodiment. A projection 35 is formed on the front wall of the L type seat block 34 (see Fig. 7, Fig. 8 and Fig. 10). The L type seat 34 is fixed to the cooling block 44 by screwing screws 37 through screw holes 36, such that the front of the projection 35 steadily contacts with the metallic base 22 of the FET 12. The holes 36 have an elongated inner length in the direction of D-D, allowing the adjustment of the position of the L type seat 34 in the same direction in accordance with the semiconductor device to be tested. As a result, since the cooling block 44 is usually electrically grounded, the ground potential is provided to the FET 22 through the contact between the projection 35 and the metallic base 22.

## Claims

1. A high temperature environmental testing apparatus having a setting device for setting a semiconductor device (12) to be tested which includes a thermally and electrically conductive base member (22), said setting device comprising :

   a microstrip matching circuit having a plurality of microstrip matching circuit plates (10) each plate (10) including an electrically insulative substrate (13), said microstrip matching circuit being operatively connectable to said semiconductor device (12);

   an output terminal means (16) connected to said microstrip matching circuit, for providing said microstrip circuit plates (10) with signals;

   a grounding means (17;35) for electrically grounding said semiconductor device (12); and

a heat block (15) for heating said semiconductor device (12);

characterized in that said setting device further comprises:

a microstrip matching pattern (19) formed on the top surface of each substrate (13);

a grounding pattern (18) formed on the back side of each substrate (13), and connected to said output terminal means (16);

a cooling block (14;44) for cooling said microstrip matching circuit mounted on said cooling block (14;44); and

supporting means (27, 28) for supporting said heat block (15),

said heat block (15) being attachable to said base member (22) of said semiconductor device (12) in surface-to-surface contact, being heated by a heating source, and being supported by said supporting means (27, 28) such that said heat block (15) is positioned spatially isolated from said cooling block (14) by an air space except for the portion where said supporting means (27, 28) contacts thereto.

2. An apparatus according to claim 1, characterized in that said grounding means is a metallic foil (17).

3. An apparatus according to claim 2, characterized in that said metallic foil (17) is made of copper and is gold plated.

4. An apparatus according to any one of claims 2 and 3, characterized in that said metallic foil (17) is electrically connected to said grounding pattern (18) of said microstrip matching circuit plate.

5. An apparatus according to any one of claims 2 to 4, characterized in that said metallic foil (17) is electrically connected to said cooling block (14).

6. An apparatus according to any one of claims 2 to 5, characterized in that said metallic foil (17) is inserted between said heat block (15) and said base member (22) of said semiconductor device (12), and said metallic foil (17), said heat block (15) and said base member (22) are tightly contacted to each other.

7. An apparatus according to claim 1, characterized in that said grounding means is a projection (35) formed on a side wall of said cooling block (44) facing to a surface of said base member (22) of said semiconductor device (12), and disposed such that the confronting surface of said projection (35) is in electrical contact with said base member (22).

8. An apparatus according to claim 7, characterized in that it further comprises a metallic seat block (34) on which said microstrip matching circuit is disposed and said projection (35) is formed on a wall of said metallic seat facing said metallic base (22) of said semiconductor device (12).

9. An apparatus according to any one of claims 1 to 8, characterized in that said supporting means comprises a pair of supporting plates (27,28) made of metal.

10. An apparatus according to claim 9, characterized in that said supporting plates (27,28) are attached to said heat block (15) at portions in the vicinity of the ends of said heating block, while the portion where said semiconductor device (12) is to be set is the center of said heat block (15).

11. An apparatus according to any one of claims 9 and 10, characterized in that each supporting plate (27,28) is fixed to said heat block (15) with the facing surfaces of said heat block and said supporting plates being spaced by a ceramic spacer (30).

12. A method for performing a high temperature environmental test of a semiconductor device employing the apparatus recited in any one of claims 1 to 11, comprising the steps of :

mounting said semiconductor device (12) on said heat block (15) ;

connecting leads of said semiconductor device to transmission lines (19a) of said microstrip matching circuit plates (10) ;

raising the temperature of said semiconductor device (12) to a predetermined value by heating said heat block (15), and maintaining said temperature ; and

applying an input signal and the ground potential to said semiconductor device through said transmission lines (19a).

**Patentansprüche**

1. Vorrichtung zum Testen unter hoher Umgebungstemperatur, mit einer Einspanneinrichtung zum Einspannen einer Halbleitervorrichtung (12), die getestet werden soll, welche ein termisch und elektrisch leitendes Basisteil (22) enthält, welche Einspannvorrichtung umfaßt:

eine Mikrostreifen-Anpassungsschaltung, die eine Vielzahl von Mikrostreifen-Anspassungsplatten (10) hat, von denen jede Platte (10) ein elektrisch isolierendes Substrat (13) hat, welche Mikrostreifen-Anpassungsschaltung betreibbar ist, um mit der genannten Halbleitervorrichtung (12) verbindbar zu sein;

einer Ausgangsanschlußeinrichtung (16), die mit der Mikrostreifen-Anpassungsschaltung verbunden ist, um den Mikrostreifen-Schaltungsplatten (10) Signale zu liefern;

einer Erdungseinrichtung (17; 35), um die Halbleitervorrichtung (12) elektrisch zu erden; und

einem Heizblock (15), um die Halbleitervorrichtung (12) zu heizen;

dadurch gekennzeichnet, daß die Einspannvorrichtung ferner umfaßt:

ein Mikrostreifen-Anpassungsmuster (19), das auf der oberen Oberfläche von jedem Substrat (13) gebildet ist;

ein Erdungsmuster (18), welches auf der Rückseite von jedem Substrat (13) gebildet und mit den Ausgangsanschlußeinrichtungen (16) verbunden ist;

einen Kühlblock (14; 44), zum Kühlen der Mikrostreifen-Anpassungsschaltung, die auf dem Kühlblock (14; 44) montiert ist; und

Trageinrichtungen (27, 28), zum Tragen des Heizblockes (15),

wobei der genannte Heizblock (15) an dem Basisteil (22) der Halbleitervorrichtung (12) in einem Oberfläche-an-Oberfläche-Kontakt befestigt werden kann, durch eine Heizquelle erhitzt wird, und durch die Trageinrichtung (27, 28) so getragen wird, daß der Heizblock (15) von dem Kühlblock (14) durch einen Luftspalt räumlich isoliert angeordnet ist, mit Ausnahme des Abschnittes, wo die Trageinrichtung (27, 28) ihn berührt.

2. Vorrichtung nach Anspruch 1, dadurch gekennzeichnet, daß die Erdungseinrichtung eine Metallfolie (17) ist.

3. Vorrichtung nach Anspruch 2, dadurch gekennzeichnet, daß die genannte Metallfolie (17) aus Kupfer besteht und mit Gold plattiert ist.

4. Vorrichtung nach einem der Ansprüche 2 und 3, dadurch gekennzeichnet, daß die genannte Metallfolie (17) mit dem Erdungsmuster (18) der Mikrostreifen-Anpassungsschaltungsplatte elektrisch verbunden ist.

5. Vorrichtung nach einem der Ansprüche 2 bis 4, dadurch gekennzeichnet, daß die Metallfolie (17) mit dem Kühlblock (14) elektrisch verbunden ist.

6. Vorrichtung nach einem der Ansprüche 2 bis 5, dadurch gekennzeichnet, daß die Metallfolie (17) zwischen dem Heizblock (15) und dem Basisteil (22) der Halbleitervorrichtung (12) eingefügt ist, und die Metallfolie (17), der Heizblock (15) und das Basisteil (22) in engem Kontakt miteinander sind.

7. Vorrichtung nach Anspruch 1, dadurch gekennzeichnet, daß die genannte Erdungseinrichtung ein Vorsprung (35) ist, der auf einer Seitenwand des Kühlblockes (44) gebildet ist, einer Oberfläche des Basisteils (22) der Halbleitervorrichtung (12) zugewandt, und so angeordnet ist, daß die gegenüberliegende Oberfläche des Vorsprungs (35) mit dem Basisteil (22) in elektrischem Kontakt ist.

8. Vorrichtung nach Anspruch 7, dadurch gekennzeichnet, daß sie ferner einen metallischen Sitzblock (34) umfaßt, auf dem die Mikrostreifen-Anpassungsschaltung angeordnet ist, und der Vorsprung (35) auf einer Wand der metallischen Sitzfläche, welche der Metallbasis (22) der Halbleitervorrichtung (12) zugewandt ist, gebildet ist.

9. Vorrichtung nach einem der Ansprüche 1 bis 8, dadurch gekennzeichnet, daß die genannte Trageinrichtung ein Paar von Tragplatten (27, 28) umfaßt, die aus Metall hergestellt sind.

10. Vorrichtung nach Anspruch 9, dadurch gekennzeichnet, daß die genannten Tragplatten (27, 28) an dem Heizblock (15) an Abschnitten in der Nähe der Enden des Heizblockes angebracht sind, während der Abschnitt, wo die Halbleitervorrichtung (12) eingespannt werden soll, im Zentrum des Heizblockes (15) ist.

11. Vorrichtung nach einem der Ansprüche 9 und 10, dadurch gekennzeichnet, daß jede Tragplatte (27, 28) an dem Heizblock (15) fixiert ist, wobei die einander zugewandten Oberflächen des Heizblockes und der Tragplatten durch einen keramischen Abstandshalter (30) voneinander beabstandet sind.

12. Verfahren zur Durchführung eines Testes einer Halbleitervorrichtung unter hoher Umgebungstemperatur, unter Verwendung einer Vorrichtung nach einem der Ansprüche 1 bis 11, mit den folgenden Schritten;

Montieren der Halbleitervorrichtung (12) auf dem Heizblock (15);

Anschließen von Leitungen der Halbleitervorrichtung an Übertragungsleitungen (19a) der Mikrostreifen-Anpassungsschaltungsplatten (10);

Erhöhen der Temperatur der Halbleitervorrichtung auf einen vorbestimmten Wert, durch Heizen des Heizblockes (15), und Aufrechterhalten der genannten Temperatur;

Aufbringen eines Eingangssignals und des Erdpotentials durch die Transmissionsleitungen (19a) auf die Halbleitervorrichtung.

## Revendications

1. Appareil de contrôle en milieu de haute température, possédant un dispositif de positionnement qui sert à positionner un dispositif à semiconducteur (12) devant être contrôlé, qui comporte un élément de base thermiquement et électriquement conducteur (22), ledit dispositif de positionnement comprenant :

un circuit d'adaptation microbande possédant une pluralité de plaques de circuit d'adaptation microbande (10), chaque plaque (10) comportant un substrat électriquement isolant (13), ledit circuit d'adaptation microbande pouvant être fonctionnellement connecté audit dispositif à semiconducteur (12) ;

un moyen formant une borne de sortie (16) connecté audit circuit d'adaptation microbande, et servant à fournir des signaux auxdites plaques de circuit microbande (10) ;

un moyen de mise à la terre (17 ; 35) servant à mettre électriquement à la terre ledit dispositif à semiconducteur (12) ; et

un bloc thermique (15) servant à chauffer ledit dispositif à semiconducteur (12) ;

caractérisé en ce que ledit dispositif de positionnement comprend en outre :

un motif d'adaptation microbande (19) formé sur la surface supérieure de chaque substrat (13) ;

un motif de mise à la terre (18) formé sur l'envers de chaque substrat (13) et connecté audit moyen formant une borne de sortie (16) ;

un bloc de refroidissement (14 ; 44) servant à refroidir ledit circuit d'adaptation microbande monté sur ledit bloc de refroidissement (14 ; 44) ; et

un moyen de support (27 ; 28) servant à porter ledit bloc thermique (15),

ledit bloc thermique (15) pouvant être fixé audit élément de base (22) dudit dispositif à semiconducteur (12) suivant un contact surface contre surface, étant chauffé par une source de chauffage, et étant porté par ledit dispositif de support (27 ; 28) de façon que ledit bloc thermique (15) soit disposé en une position spatialement isolée dudit bloc de refroidissement (14) par un espace rempli d'air sauf pour la partie où ledit moyen de support (27 ; 28) est en contact avec lui.

2. Appareil selon la revendication 1, caractérisé en ce que ledit moyen de mise à la terre est une feuille métallique (17).

3. Appareil selon la revendication 2, caractérisé en ce que ladite feuille métallique (17) est faite de cuivre et est plaquée d'or.

4. Appareil selon l'une quelconque des revendications 2 et 3, caractérisé en ce que ladite feuille métallique (17) est électriquement connectée audit motif de mise à la terre (18) de ladite plaque de circuit d'adaptation microbande.

5. Appareil selon l'une quelconque des revendications 2 à 4, caractérisé en ce que ladite feuille métallique (17) est électriquement connectée audit bloc de refroidissement (14).

6. Appareil selon l'une quelconque des revendications 2 à 5, caractérisé en ce que ladite feuille métallique (17) est insérée entre ledit bloc thermique (15) et ledit élément de base (22) dudit dispositif à semiconducteur (12), et ladite feuille métallique (17), ledit bloc thermique (15) et ledit élément de base (22) sont mis en contact étroit les uns avec les autres.

7. Appareil selon la revendication 1, caractérisé en ce que ledit moyen de mise à la terre est une partie saillante (35) formée sur une paroi latérale dudit bloc de refroidissement (44) en regard d'une surface dudit élément de base (22) dudit dispositif à semiconducteur (12), et disposée de façon que la surface de ladite partie saillante (35) situé en regard soit en contact électrique avec ledit élément de base (22).

8. Appareil selon la revendication 7, caractérisé en ce qu'il comprend en outre un bloc d'appui métallique (34) sur lequel ledit circuit d'adaptation microbande est disposé et ladite partie saillante (35) est formée sur une paroi dudit bloc d'appui métallique se trouvant en regard de ladite base métallique (22) dudit dispositif à semiconducteur (12).

9. Appareil selon l'une quelconque des revendications 1 à 8, caractérisé en ce que ledit moyen de support comprend deux plaques de support (27, 28) faites de métal.

10. Appareil selon la revendication 9, caractérisé en ce que lesdites plaques de support (27, 28) sont fixées audit bloc thermique (15) en des parties situées au voisinage des extrémités dudit bloc thermique, tandis que la partie où ledit dispositif à semiconducteur (12) doit être positionné est le centre dudit bloc thermique (15).

11. Appareil selon l'une quelconque des revendications 9 et 10, caractérisé en ce que chaque plaque de support (27, 28) est fixée audit bloc thermique (15) de façon que les surfaces en regard dudit bloc thermique et **desdites plaques** de support soient séparées par un élément d'écartement en céramique (30).

12. Procédé permettant d'effectuer un contrôle en milieu de haute température sur un dispositif à semiconducteur à l'aide de l'appareil selon l'une quelconque des revendications 1 à 11, comprenant les opérations suivantes :

monter ledit dispositif à semiconducteur (12) sur ledit bloc thermique (15) ;

connecter des fils conducteurs dudit dispositif à semiconducteur à des lignes de transmission (19a) desdites plaques de circuit d'adaptation microbande (10) ;

élever la température dudit dispositif à semiconducteur (12) jusqu'à une valeur prédéterminée en chauffant ledit bloc thermique (15), et maintenir ladite température ; et

appliquer un signal d'entrée et le potentiel de terre audit dispositif à semiconducteur par l'intermédiaire desdites lignes de transmission (19a).

FIG. 1

PRIOR ART

FIG.2

FIG. 3

FIG. 4

FIG. 5

FIG.6

FIG.7

FIG.8

FIG.9

FIG.10